(19) Europäisches Patentamt

European Patent Office

Office européen des brevets

(11) **EP 1 094 603 A1**

(12) **EUROPEAN PATENT APPLICATION**

(43) Date of publication:
25.04.2001 Bulletin 2001/17

(51) Int. Cl.⁷: **H03K 3/84**, G06F 7/58

(21) Application number: 00308113.0

(22) Date of filing: 18.09.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 20.10.1999 JP 29842399

(71) Applicants:
• **Iwaki Electronics Co., Ltd.**
**Tokyo 105-0004 (JP)**
• **Cosmo Ec Co., Limited**
**Chiyoda-ku, Tokyo (JP)**

(72) Inventors:
• **Tsuyuzaki, Noriyoshi c/o Iwaki Electronics Co Ltd**
**Tokyo (JP)**
• **Yamamoto, Hiroyasu c/o Iwaki Electronics Co., Ltd.**
**Tokyo (JP)**

(74) Representative:
**Ertl, Nicholas Justin**
**Elkington and Fife,**
**Prospect House,**
**8 Pembroke Road**
**Sevenoaks, Kent TN13 1XR (GB)**

(54) **A random pulse generator, a random number generator and a probability random event generator**

(57)    There is provided a random pulse generator which has a PIN diode (10) for receiving a radioactive rays radiated from a radioactive material (RS) of a spontaneous decay and converting the received radioactive rays into an electrical signal of an intensity correspondent with an energy level of the received radioactive rays, an amplifier (21,22) for generating time constant signals from the electrical signals and amplify the generated time constant signals, a pulse-amplitude discriminator (23) for discriminating the time constant signals to determine that the time constant signals are of an electrical voltage level in compliance with the particles of the radioactive material, an output device for transmitting pulses from the pulse-amplitude discriminator device, and a shield device (18), between the radioactive material and the PIN diode, for shielding predetermined radioactive rays.

FIG. 1

EP 1 094 603 A1

## Description

### BACKGROUND OF THE INVENTION

1. A Field of the Invention:

The present invention relates in general to a random pulse generator and a random number generator which utilizes the random pulse generator and, in addition, a probability generator which incorporates the random pulse generator. More particularly, the present invention relates to the random pulse generator which generates, at random, electric pulses the number of which is correspondent with the number of nuclear decay particles of radioactive materials and, in addition, the present invention relates to the stochastic (or, probability) generator which generates probability by using the detected pulses from the random pulse generator.

2. Description of Prior Art:

A generally known method of generating a random number available at present includes a use of a function stored in a ROM (Read Only Memory), a use of a white noise, and production of artificial (pseudo) random numbers. The random numbers thus produced by these methods are artificial or pseudo and not complete, natural random numbers. Further, a new type of a stochastic generator has been sought which permits optional setting of a plurality of probabilities and also permits to converge appearance (occurrence) probability into setting (established) probability.

In order to avoid the deficiencies of the conventional methods, attempts have been made to provide a random pulse generator which utilizes weak radioactive material as disclosed in Japanese Patent Application (JP, 60-31640, A), and Japanese Patent Nos. 2543815, 2806736 and 2926539 (JP, 9-28899, A). Japanese Patent Application JP 60-31640, A described above teaches to generate pulses by an alpha ($\alpha$) ray radiated from americium ($^{241}$Am) which, however, is not satisfactory because the method and apparatus disclosed in this Japanese Patent application teaches to merely generate unlimitedly random pulses and does not serve to count alpha ($\alpha$) ray.

The other prior art of record as described above shows random pulse generator of a probability controllable type. However, the prior art of record does not teach or suggest utilization of the random pulse generator.

On the other hand, in a security system such as magnetic cards, it has been likely that the securities were damaged by read-out of the memory data of the cards and/or duplication of the cards by the person or persons other than the owners of the cards. In order to avoid such insecurities and to maintain the safety, the cards have been renewed.

In the conventional game machines, numbers (values) which are equivalent to the probability (stochastic) values are circulated at a predetermined cycle and one of the numbers is selected at the time of input of lottery requirement signals. When the selected numbers are consistent with the predetermined value of a "hit" or "winning", the number is determined to be a hit or winning. However, in this circulation of the numbers depends largely upon an installed program of the machine and, therefore, there have been problems that there are deviation in the "winning" or hit. In addition, the lottery method is included in and determined by the program, and there is a serious problem that probability renewed ROM is easily replaced with a regular ROM and vice versa.

Further, the probability used in the machines is of man-made or synthetic products and it is not possible to involve or incorporate any fluctuations which are contained in natural phenomena.

In the magnetic cards, a user of the card is recognized as the true owner of the card when numbers and/or characters or marks driven (inputted) by the user are found to be equivalent to the stored data stored of the cards. However, it is quite easy to read out the data of the card and to reduce duplicates to use illegally.

Further, in the prior art of record, a radioactive rays such as alph ray is detected by a PIN idode (in other words, a photo-diode) and random pulses are generated in response to the detected results of the PIN diode. However, in this prior art described above, if it is required to descriminate or select a specific radioactive ray, such as beta ray, among a various kinds of radioactive rays radiated from radioactive material, it is necessary to apply troublesome and difficult applications such as modification of a thickness in an I (intrinsic) layer of the PIN diode. Consequently, the conventional random number gernerator and probability generator, the both of which utilize the random pulse generator described above have disadvantages in an unavoidable increase of production cost.

### SUMMARY OF THE INVENTION

The present invention seeks to solve the above problems of the conventional technique and to provide a new random pulse generator which permits an easy and reliable selection or discrimination of a specific radio active ray or rays. The random pulse generator is particularly applicable for use in a random number generator or a probability generator.

The present invention also seeks to provide a random pulse generator which permits generation of a complete random numbers, without any deviation, with the utilization of radioactive rays radiated from spontaneously delayed (disintegrated) radioactive materials, and also a new random number generator and a probability generator both of which utilize the random pulse generator which permits no illegal usage.

Furthermore, the present invention seeks to provide a new system which can prevent copying of data within a card or similar device by embedding a radiation source into the card, or by embedding a random pulse generator (RPG). Because the radiation source or RPG cannot be copied, an authentic copy of the card or similar device cannot be made.

According to an aspect of the present invention, there is provided a random pulse generator comprising:

a PIN diode for receiving a radioactive rays radiated from a radioactive material of a spontaneous decay and converting the received radioactive rays into an electric signal of an intensity correspondent with an energy level of the received radioactive rays,

amplifier means for generating time constant signals from the electrical signals and amplify the generated time constant signals,

pulse-amplitude discriminator means for discriminating the time constant signals to determine that the time constant signals are of an electrical voltage level in compliance with the particles, and

output means for transmitting pulses from the pulse-amplitude discriminator circuit means, and

shield means, between the radioactive material and the PIN diode, for shielding predetermined radioactive rays and permitting a specified ray to be solely passed therethrough to the PIN diode.

In a second aspect of the present invention, there is provided a random pulse pulse generator comprising:

a PIN diode having an I (intrinsic) layer of a suitable thickness for measurement of ionization current of radiation so that alpha ($\alpha$) ray is selectively detected among other radioactive rays radiated from a radioactive material of a spontaneous decay, and having a structure for shielding an outer light,

conversion means for converting, with the use of the PIN diode, the particles into electrical signals having an intensity correspondent with an energy level of the particles,

amplifier means for generating time constant signals from the electrical signals and amplify the generated time constant signals,

pulse-amplitude discriminator means for discriminating the time constant signals to determine that the time constant signals are of an electrical voltage level in compliance with the particles, and

output means for transmitting pulses from the pulse-amplitude discriminator circuit means, so that when an electrical voltage range is assigned with respect to the voltage pulse generated by the PIN diode, an electrical voltage level of passable pulses can be arbitrarily determined, and,

shield means, between the radioactive material and the PIN diode, for shielding predetermined radioactive rays and permitting a specified ray to be solely passed therethrough to the PIN diode.

In a preferred feature of the random pulse generator according to the present invention, the radioactive material is selected from nuclides of $^{244}$Cm, $^{241}$Am, U$_3$O$_8$, $^{210}$Pb, $^{60}$Co, $^{137}$Cs, $^{90}$Sr, $^{22}$Na, $^{51}$Cr, $^{54}$Mn, $^{57}$Co, $^{133}$Ba, nuclides of uranium series, nuclides of thorium series, nuclides of actinium series, and naturally existing radioactive nuclides.

In another feature of the present invention, there is provided a random number generator comprising:

a random pulse generator having a PIN diode for receiving a radioactive rays radiated from a radioactive material of a spontaneous decay and converting the received radioactive rays into an electric signal of an intensity correspondent with an energy level of the received radioactive rays, amplifier means for generating time constant signals from the electrical signals and amplify the generated time constant signals, pulse-amplitude discriminator means for discriminating the time constant signals to determine that the time constant signals are of an electrical voltage level in compliance with the particles, output means for transmitting pulses from the pulse-amplitude discriminator circuit means, and shield means, between the radioactive material and the PIN diode, for shielding predetermined radioactive rays and permitting a specified ray to be solely passed therethrough to the PIN diode, and output means for receiving the pulses from the random pulse generator, calculating the number of the random pulses by a predetermined time interval, and transmitting the number of the pulses as an output of random numbers.

In a further feature of the present invention, there is provided a probability generator comprising:

a random pulse generator having a PIN diode for receiving a radioactive rays radiated from a radioactive material of a spontaneous decay and converting the received radioactive rays into an electric signal of an intensity correspondent with an energy level of the received radioactive rays, amplifier means for generating time constant signals from the electrical signals and amplify the generated time constant signals, pulse-amplitude discriminator means for discriminating the time constant signals to determine that the time constant signals are of an electrical voltage level in compliance with the particles, output means for transmitting pulses from the pulse-amplitude discriminator circuit means, and shield means, between the radioactive material and the PIN diode, for shielding predetermined radioactive rays and permitting a specified ray to be solely passed therethrough to the PIN diode, and

pulse counting means for receiving the pulses from the random pulse generator, calculating the number of the random pulses by a predetermined time interval, and

signal output means for transmitting a predetermined signal ("hit" singnal) when the number of the pulses calculated by the pulse counter means is coincident with the number of the pulses correspondent with a predetermined probability.

In another aspect of the invention, there is provided a probability generator which proceeds comparison between the number of the measured pulses and the number of pulses correspondent with a probability (stochastic) value calculated from a Poison's distribution and Gaussian distribution, and generate a "hit" (or "winning") signal pulse when the number of pulses measured in a predetermined time is coincident with the number of pulses correspondent with the stochastic (probability) value.

In the probability generator described above, in order to avoid fluctuation in probability values due to reduction of the number of discharged particles by the half-life of the using radiation source, the number of discharged particles from the radiation source is measured constantly or cyclically so that a probability can be determined in accordance with the measured number of the particles.

In another embodiment of the probability generator described above, a plurality of probability values directly calculated from a Poison's distribution and Gaussian distribution and a probability value calculated from a combination of same or different probability values are set.

In the probability generator described above, a comparison requirement signal is transmitted as an input to the circuit, and the number of pulses measured in a predetermined time interval before and after the input of the comparison requirement signal is compared with the comparison requirement signal.

In a preferred embodiment of the random numbers generator/probability generator described above, the circuits and circuit means described above are formed as an integrated circuit on a single substrate and sealed in a package and means is provided for shifting an operation mode into an inoperable mode in case that the package is opened or undesirable signal is transmitted from connector terminals.

In another embodiment of the random number generator/probability generator described above, the number of measured pulses, random numbers and probability data and other necessary information are transmitted for external services through optical or electromagnetic media.

In a preferred embodiment, the random numbers generator/probability generator described above has a thickness of 0.7 mm or less and embedded into a card.

In another preferred embodiment, the random numbers generator/probability generator utilizing single or a plurality of radioactive materials, comprising means for discriminating the difference of, at least, a half-life, a density of a radioactive material and an intensity of radiation so that discrimination of an original from a forgery is available.

In a further embodiment of the invention, the random numbers generator/probability generator utilizes nuclides of spontaneous declay (disintegration) so that usable time limit is defined by a radiation damage of a PIN diode.

In another embodiment of the random number generator / probability generator of the invention, a minimum number of pulses for detection is predetermined to be a value of a detection limit to thereby define a period of use.

In the present invention, decay of alpha (α) ray, beta (β) ray and gamma (γ) ray radiated from radioactive material of a spontaneous decay is detected to discriminate whether or not the random pulse generator under detection is genuine and original.

Further, in the present invention, the random pulse generated by the random pulse generator is converted into digital data and recorded in cards, and the recorded values are compared with the read-out values to thereby discriminate originality at the time of using the cards.

In the present invention, radiation such as alpha (α) ray, beta (β) ray and gamma (γ) ray radiated at random by the disintegration (decay) is detected and, at the same time, a predetermined pulse is generated. Further, discharging probability based upon a spontaneous decay is determined by the measured data so that original and genuine probability is produced with no artificial illegality.

BRIEF EXPLANATION OF THE DRAWINGS

Fig. 1 is a diagrammatic view of a basic structure of a random pulse generator incorporating a PIN diode.

Fig. 2 is a diagram showing a structural feature of the inventive random pulse generator with the PIN diode of a can-sealing type construction.

Fig. 3 is a diagram showing a structural feature of an inventive pulse generator with the PIN diode of a flat type construction.

Fig. 4 is a block diagram of a random pulse generator, a random number generator, and a probability generator circuit.

Fig. 5 is a graph showing a energy distribution of alpha (α) ray for use in the present invention.

Fig. 6 is a diagram showing an example of probability calculation of Poison's distribution which is used in the present invention.

Fig. 7 is a diagram showing an example of probability calculation of Gaussian distribution which is used in the present invention.

Fig. 8 is diagrammatic perspective view of the device of the present invention, showing an example of data trasmission by optical and electromagnetic media according to the present invention.

Fig. 9 is a diagram showing an example of fitting the inventive device to an IC card.

Fig. 10 is a graph showing a decay curve which is used in the present invention.

Fig. 11 shows an example of a thin film type in which a plurality of PIN diodes each incorporating a radiation source.

Fig. 12 shows an example of a can type in which a plurality of PIN diodes each incorporating a radiation source.

Fig. 13 is a perspective view of a PIN diode with a radiation source which is surrounded at its sides portions.

REFERRED EMBODIMENTS OF THE INVENTION

A preferred embodiments of the present invention will be described with reference to the accompanying drawings.

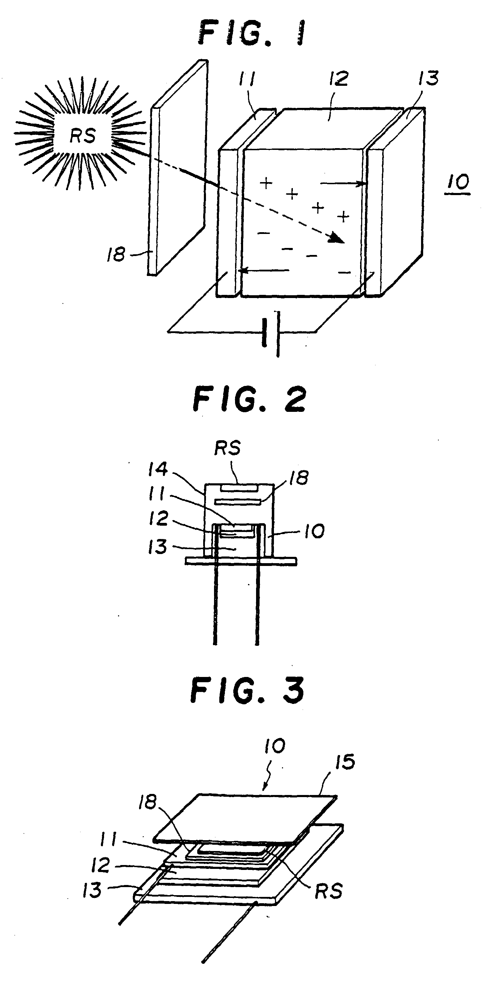

Referring first to Fig. 1 showing a basic structure of an inventive random pulse generator incorporating a PIN diode (photo-diode) 10, which has a P layer 11, an I (intrinsic) layer 12 and an N layer 13 as illustrated, for detecting $\alpha$ ray, $\beta$ ray and $\gamma$ ray radiated from a radiation source RS, nuclides of natural or synthetic radioactive materials radiate $\alpha$ ray, $\beta$ ray or $\gamma$ ray or otherwise these rays simultaneously and then subject to spontaneous decay, at which time the decay proceeds in accordance with inherent decay constant of each of the radioactive material.

As illustrated in Fig. 1, the pulse generator 10 has a shield plate 18 which is provided between the radioactive source RS and the PIN diode 10 so that unnecessary radioactive rays are shielded from being transmitted into the PIN diode 10.

In the present invention, ultra low volume radioactive materials which have no harmful effect to human body are used. A radiation interval of $\alpha$ ray, $\beta$ ray and $\gamma$ ray radiated from the radioactive material is not constant but random. For the purpose of simplification only, an explanation will be made with respect solely to alpha ($\alpha$) ray. In respect of americium [241] Am, for example, alpha ($\alpha$) ray (helium atom) is radiated at random by spontaneous decay. Alpha ray has an extremely larger mass than an electron and, therefore, provides a mutual reaction relative to the electron to generate ion pairs around its locus until energy is emitted and stops. A thickness of a material suitable for the stop of the alpha ray is about 30 μm if the material is silicon (Si). The thickness of this depends upon the materials and in case that alpha ray must be completely stopped for the purpose of, for example, seeking probability values, a care must be taken that the thickness is selected to be larger than the thicknesses which are independently and separately calculated relative to each of the materials. By contrast, in case that only ionization is satisfactory as in the case of pulse measurement, a suitable thickness can be selected as desired.

In view of the above, as far as the basic structure as shown in Fig. 1 is concerned, the thickness is optional and can be selected as desired. Further, if the thickness is made to be larger than about 30 μm, it will be necessary that the thickness is controlled such that a detection efficiency for the alpha ($\alpha$) ray is smaller than that for the other rays, but as far as the basic structure of Fig. 1 is concerned, a desired shape can be selected. However, a care must be taken that the PIN diode 10 must be treated to shield an external light if necessary because an uncovered or bare PIN diode receives and detects an external light as well.

Fig. 2 shows a structure of a radiation source incorporated PIN diode 10 having P, I and N layers 11, 12 and 13, respectively, which is can-sealed by a metal can 14 as illustrated. Between the radioactive source RS and the PIN diode 10, a shield plate 18 is provided within the can 14 so that unnecessary radioactive rays are prevented from being transmitted from the radioactive source RS to the PIN diode. This structure is suitable for a device and apparatus which have no strict limitation of size and/or shape.

In Fig. 3 which shows a structure of a flat type in which the PIN diode 10 is incorporated in an IC card and the entire thickness of the IC card is limited to 0.7 mm or less. As similar as the previous structure shown Figs. 1 and 2, a shield plate 18 is provided between the radioactive source RS and the PIN diode 10. The flat type PIN diode structure 10 has a cover or second shield 15 for shielding an outer light.

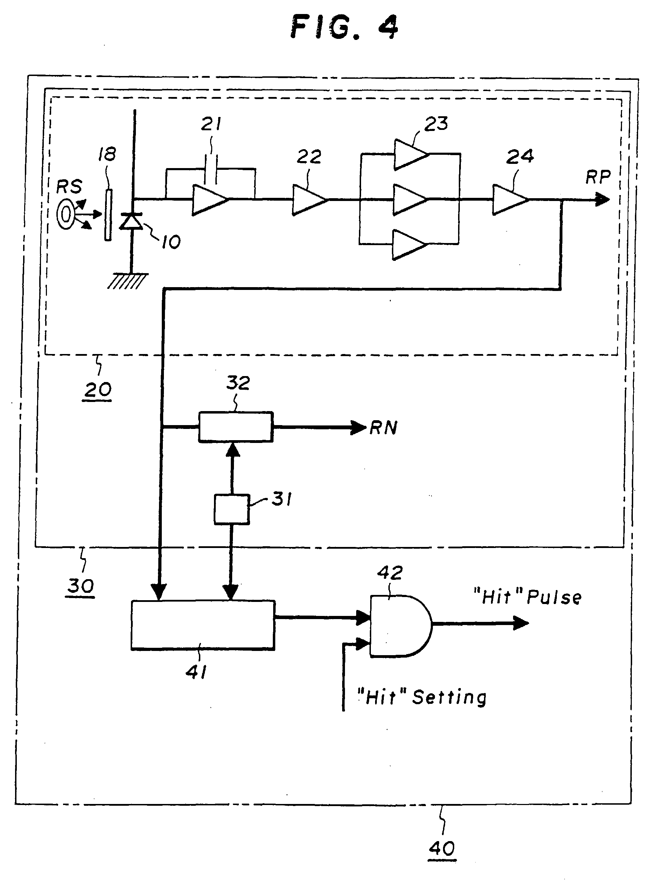

In Fig. 4, a random pulse generator 20 incorporating therein the PIN diode 10 with the shield plate 18 has a preamplifier circuit 21 and a main amplifier circuit 22 for amplifying an electric current which is detected by the radiation source incorporated PIN diode 10, a pulse-amplifier discriminator circuit 23 for passing only the pulses of radiation (radioactive rays), and a wave shaping circuit 24. By using electric circuit devices such as the pulse-amplifier (i.e., pulse-height) discriminator circuit 23, etc., a desired random pulse is generated.

The pulse-amplifier discriminator circuit 23 is comprised of a low pulse-amplifier discriminator circuit and a high pulse-amplifier discriminator circuit. The pulse which is transmitted through and by the pulse-amplifier discriminator circuit 23 is limited to the pulse of radiation (radioactive rays). The pulse of radiation is discriminated from noises by the following method. Here, in Fig. 4, reference character RP in the random pulse generator 20 represents a random pulse, and reference character RN in the random number generator 30 represents a random number.

For example, a case that a PIN diode 10 which incorporates therein [241] Am (americium) alpha ray will be explained.

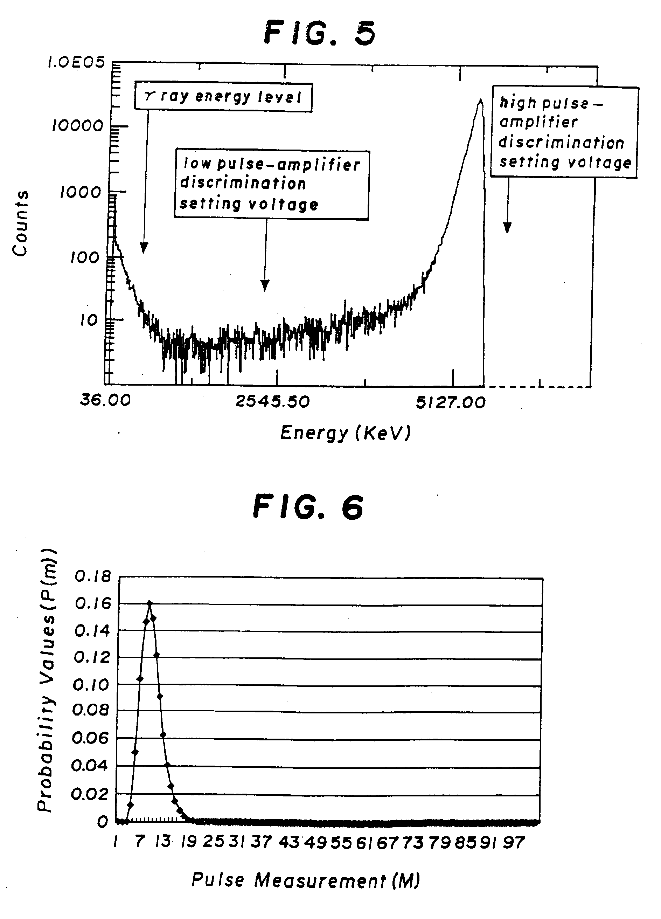

Alpha ($\alpha$) particle has an energy of about 5.4 MeV and provides an energy distribution as shown in Fig. 5 at the stage of an output of the preamplifier 21 per measured alpha ($\alpha$) particle. A range of the measured energy is, as shown in Fig. 5, has a peak at the energy level which corresponds to 5.4 MeV and has a larger distribution at the low energy side. This is due to the fact that alpha energy radiated from the radiation source is radiated in the 4 $\pi$ direction, and energy distribution is produced with respect to the emitted energy, depending upon paths or channels in the PIN diode. In Fig. 5 of the drawing, the output of the PIN diode includes a component of noise.

In the pulse-amplifier discriminator circuit 23, the aforementioned low pulse-amplifier circuit is used to cut off a low level voltage which is lower than a predetermined voltage level so as to delete a noise component of the low energy portion. When alpha ray is solely detected, a cut-off voltage is set to be higher than a pulse generation position by beta ($\beta$) and gamma ($\gamma$) ray energy so that an unnecessary pulse which is generated by beta ($\beta$) and gamma ($\gamma$) rays can be excluded.

Similarly, with respect to the other rays than alpha ($\alpha$) ray described above, the pulse by the objective radiation source can be discriminated. Therefore, the pulse which passed through the pulse-amplitude discriminator circuit 23 is correspondent with the particles which are radiated by a spontaneous decay and is a complete random pulse.

In the random pulse generator circuit 20 shown in Fig. 4, the radioactive material for the radioactive source RS is preferably selected from nuclides of $^{244}$Cm, $^{241}$Am, $U_3O_8$, $^{210}$Pb, $^{60}$Co, $^{137}$Cs, $^{90}$Sr, $^{22}$Na, $^{51}$Cr, $^{54}$Mn, $^{57}$Co, $^{133}$Ba, nuclides of uranium series, nuclides of thorium series, nuclides of actinium series, and naturally existing radioactive nuclides. The nuclides which radiate beta ($\beta$) and other rays to subject to decay to change to the other nuclides can be used if alpha ($\alpha$) ray is radiated in the process of the decay and disintegration.

With reference again to Fig. 4, a random number generator 30 is provided with the aforementioned random pulse generator 20 and a clock pulse generator 31 and a time measurement device 32. The pulse transmitted from the random pulse generator 20 and a pulse interval thereof are measured by a pulse which is generated by the clock pulse generator 31 and then the measured numbers are determined to be random numbers. In Fig. 4, a reference character RN represents random number.

In a preferred embodiment of the invention, the random number generator 30 generates random numbers of a predetermined bit (binary digit) and the number of bit is available from 1 (one) bit.

In the random number generator described above, random number RN of a predetermined number of column (digit) is generated.

Further, according to the present invention, there is provided a probability generator 40 which proceeds comparison between the number of the measured pulses and the number of pulses correspondent with a probability (stochastic) value calculated from a Poison's distribution and Gaussian distribution, and generate a "hit" (or "winning") signal pulse when the number of pulses measured in a predetermined time is coincident with the number of pulses correspondent with the stochastic (probability) value. In Fig. 4 of the drawing, reference numerals 41 and 42 represent a counter and a comparator, respectively, which form a part of the probability generator 40. The probability generator 40 incorporates the random pulse generator 20.

Radiation decay (measured value) at a predetermined time is a phenomena which are dependent upon a principle of probability. Thus, even if a predetermined radiation source is measured for a predetermined time, the obtained values are not always constant but dispersed or varied around a mean value M. This dispersion is given by Poison's distribution formula:

$$P(m) = \frac{M^m}{m!} e^{-M} \qquad (1)$$

wherein,

p(m) : a probability for obtaining "m" count (the number of pulses) at a predetermined time
m : a measured value obtained by a measurement for a predetermined time, and
M : mean value of "m" after a number of measurements.

If the value M is more than dozens, it is nearly equal to Gaussian distribution formula as set forth below:

$$P(m) = \frac{1}{\sqrt{2\pi M}} e^{-\frac{(M-m)^2}{2M}} \qquad (2)$$

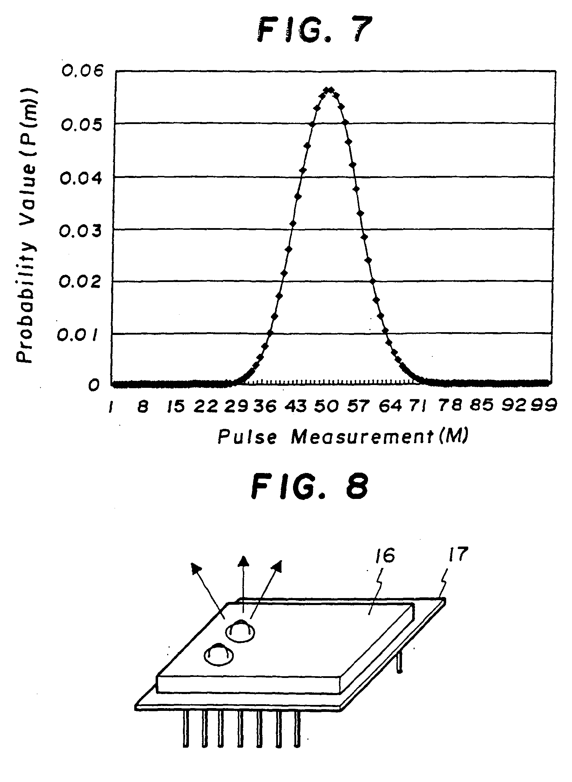

Thus, if the number of alpha ray radiation of the used radiation source or, in other words, an average number of pulses (M) measured by the PIN diode 10 is given, an appearance probability P(m) relative to the measured number (m) is basically determined. Poison's distribution and Gaussian distribution are shown in Figs. 6 and 7, respectively.

In another embodiment of the probability generator 40 described above, a plurality of probability values directly calculated from a Poison's distribution and Gaussian distribution and a probability value calculated from a combination of same or different probability values are set. In this embodiment, different probability values are determined based upon Figs. 6 and 7 and in view of formula (1) and (2). In case of using Gaussian distribution to set a probability value, however, a care must be taken that when Gaussian distribution is used, there are the same probability values by the same measured value at the left and right portions relative to a center of the average or mean value (M). In this respect, as indicated by formula (3) set forth below, two probabilities are combined to set a single probability value and, in this case, the formula (3) uses the same value but it is appreciated that two or more values can be used in combination to set the desired value.

$$\frac{1}{A} + \frac{1}{A} = \frac{2}{A} \qquad (3)$$

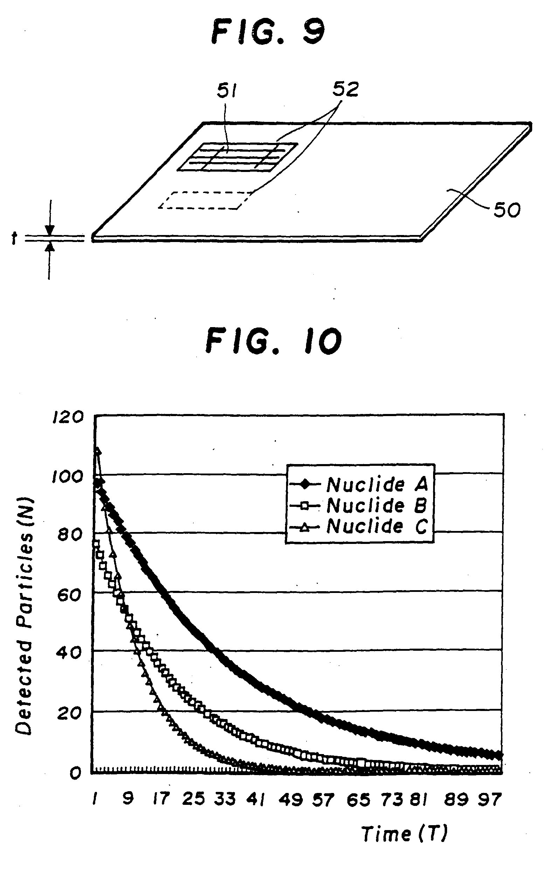

In another embodiment of the random number generator 30 and the probability generator 40 described above, as shown in Fig. 8, the number of measured pulses, random numbers and probability data and other necessary information are transmitted for external services through optical or electromagnetic media. The data are transmitted as shown by arrows in Fig. 10 by way of optical media such as infrared radiation and electromagnetic media.

In a preferred embodiment, the random number generator 30 and the probability generator 40 described above has a thickness of 0.7 mm or less and embedded into a card as an IC card. In the conventional technique of IC cards, there has been realized an IC card with CPU and the circuit structure with a thickness of 0.7 mm or less is available by the conventional technique except for PIN diodes. With respect to PIN diodes, a thickness of 30 μm as described above is satisfactory and the circuit of this thickness can be embedded into the IC card with a sufficient margin. An example is shown in Fig. 9 which shows an IC card 50. If necessary or desired, a PIN diode 10 can be incorporated into an IC of the conventional IC cards 50 to provide a unitary structure of a single IC. In Fig. 9, the IC card 50 which has a thickness (t) of 0.7 mm or less has an IC embedding position 51 and random number generator / probability generator (30, 40) embedding position 52 as illustrated.

In another preferred embodiment, the random numbers generator 30 and the probability generator 40 utilizing a single or a plurality of radioactive material(s), comprising means for discriminating the difference of, at least, a half-life, a density of a radioactive material and an intensity of radiation so that discrimination of an original from a forgery is available. As shown in Fig. 10, a plurality of nuclides having different half-life of spontaneous decay are used and, alternatively, a plurality of radioactive materials having different radioactivity concentration (the number of radiation in production) are used so that an easy judgement or discrimination of either genuine or forgery can be performed.

In a further embodiment of the invention, the random numbers generator 30 and the probability generator 40 each utilizes nuclides of spontaneous decay (disintegration) so that usable time limit is defined by a radiation damage of a PIN diode 10.

In a further modified embodiment of the random number generator 30 and the probability generator 40 of the present invention, a minimum number of pulses for detection is predetermined to be a value of a detection limit to thereby define a period of use.

It is likely that the PIN diodes 10, depending on their materials, shows a rapid decrease in detective sensitivity by an exposure of a predetermined irradiation and its limitation is substantially determined and, therefore, an operation time until the rapid reduction of the detective sensitivity can be set as a usable time.

In the nuclides of spontaneous decay type as shown in Fig. 10, the number of radiation decreases at a constant rate in accordance with the half-life thereof and, therefore, if a minimum number for the detection is predetermined, the time until the minimum number is realized can be set as a usable time. The usable time can be set in programming or by an electronic circuit.

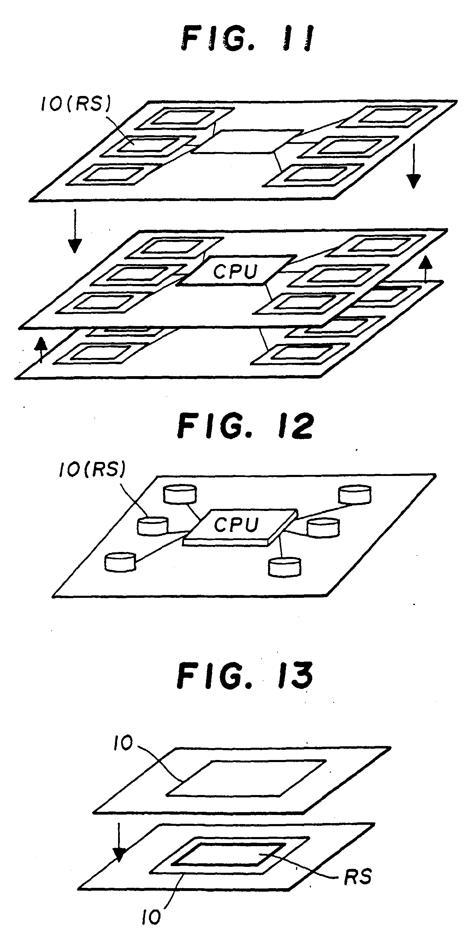

Figs. 11 and 12 showing an embodiment of a random number generator 30 (Fig. 1) according to the invention which uses a plurality of PIN diodes 10. The PIN diode 10 of Figs. 11 and 12 has radiation source (RS) incorporating therein. It is to be understood that a plurality of the random number generators 30 can be used if required as shown in Fig. 14.

Fig. 13 shows an embodiment in which the radiation source (RS) is surrounded or confined circumferentially at its opposite sides. This structure permits a substantially same level of counting when an intensity of radiation source is reduced to be a half of the radiation source of the other embodiments.

With reference to application of the random number generator 30 described above, it can be used in scanning by connecting, in an interlocking manner, the random pulses with cameras, aiming devices, radars. The random scanning as described above is more effective in short-time capturing of the objectives than the conventional sequential scanning.

The random pulse and probability of the random number generator 30 according to the present invention includes fluctuations which are inherent to the natural phenomena. Thus, the random pulse generator 30 of the present invention is extensively used for prediction in various fields such as prediction for behavior or emotion of persons, prediction of bio-scientific results, prediction of natural phenomena as weather and atmospheric phenomena, etc.

By incorporating a nuclide, a single or combined type, of a spontaneous decay type on a surface of a card and the like in an arrangement of bar-code configuration or random configuration, the positioning and an intensity of the radiation can be used as a security code. With reference to an available and limiting duration, selection and/or combination of nuclides can easily provide desired cards or the like which can be placed into an unusable conditions due to the termination of the effective duration by the decay. Further, the cards can be used as an I.D. cards of the users.

According to the present invention, a spontaneous decay of a radioactive material which is a random phenomena in the nature, is used and, therefore, no fluctuation due to production technique and/or time changing is generated, with the result that a fair and impartial "hit" probability can be constantly obtained. If, for example, the probability generator of the present invention is mounted on a game machine such as a pinball machine and "hits" or "winnings" are successively realized, the probability of the "hit" in a long period of time such as a one-day unit becomes constant. Further, there will be less dispersion in the game machines. In the present invention, the probability generator can be separately manufactured apart from the game machine and therefore easy handling is achieved, and inspection and examination can be carried out readily. The random numbers generator according to the present invention can be applied to simulation experiments which uses random numbers.

Further, if a comparison is made between the "hit" pulse generated by the probability generator and an output signal for causing a final "hit" motion and examine whether the "hit" pulse generated by the probability generator is identical with the output signal for the final "hit" motion, errors and unauthorized actions can be judged after the procedure of the probability generator. In the present invention, a radioactive material which radiates alpha, beta and gamma rays is arranged in a desired configuration such as bar-code configuration and random configuration so that the positional configuration and/or intensity (concentration) is determined to be peculiar feature of each of the cards such as an ID card.

The present invention is applicable not only to the cards as described but also other items which have security functions. In the present invention, radioactivity concentration or intensity of the radiation source is changing due to a spontaneous decay by the half life of each of the radiation sources and, therefore, it is impossible to produce two or more cards that have the same data, and copying of the card is not possible.

In the present invention, cards which are known in the art can be used by additionally storing the necessary data such as the random numbers or the like which were produced by the random number generator. It must be proceeded that the numbers added to the cards are not known to any body including the owner and the card issuer. If renewals are made by the numbers from the random generator every time when the card is used, copying and unauthorized use of the card can be prevented definitely. Further, if the random number generator is formed in a chip and incorporated into the card, the security function can be improved further.

In the present invention, a half life of the radioactive material for use of the random number generator and the probability generator is selected as desired and, consequently, a time limitation of the use of the generators can be added automatically. Every radiation source incorporated into the card is attenuated in its predetermined half life along with reduction of its remaining time. By specifying the number of decay at the time of use in view of the time passage, it is possible to clarify that the used card is genuine (original) or not. Further, in the present invention, it is possible to produce only a single original card and not copy is possible and therefore the present invention is useful for use in the field of secrecy such as for a door card, banking card, passport, etc.

A termination or usable period of the generator can be selected by selective combination of the nuclides to be used so that the card which is beyond the usable period is not available after the termination of the usable period, and the production of such cards is readily proceed in the present invention. The random pulse and probability of the random number generator 30 according to the present invention includes fluctuations which are inherent to the natural phenomena. Thus, the random pulse generator 20 of the present invention is extensively used for prediction in various fields, such as prediction for behavior or emotion of persons, prediction of bio-scientific results, prediction of natural phenomena as weather and atmospheric phenomena, etc.

**Claims**

1. A random pulse generator (10, 20) comprising:

   a PIN diode (11-13) for receiving radioactive rays radiated from a radioactive material of a spontaneous decay, conversion means for converting the received radioactive rays into an electrical signal of an intensity corresponding to an energy level of the received radioactive rays,
   amplifier means (21,22) for generating time constant signals from the electrical signals and amplify the generated time constant signals,
   pulse-amplitude discriminator means (23) for discriminating the time constant signals to determine that the time constant signals are of an electrical voltage level in compliance with the particles, and
   output means for transmitting pulses from the pulse-amplitude discriminator means, and
   shield means (18), between the radioactive material and the PIN diode, for shielding predetermined radioactive rays and permitting a specified ray to be solely passed therethrough to the PIN diode.

2. A random pulse generator according to claim 1, wherein the PIN diode (11-13) has an I (intrinsic) (12) layer of a suitable thickness for measurement of ionization current of radiation so that alpha ($\alpha$) ray is selectively detected among other radioactive rays radiated from a radioactive material of a spontaneous decay, and has a structure for shielding an outer light,

the conversion means converting, with the use of the PIN diode, the particles into electrical signals having an intensity corresponding to an energy level of the particles, and the output means being arranged so that when an electrical voltage range is assigned with respect to the voltage pulse generated by the PIN diode, an electrical voltage level of passable pulses can be arbitrarily determined.

3. A random pulse generator according to claim 1 or 2, wherein the radioactive material is selected from nuclides of $^{244}$ Cm, $^{241}$ Am, $U_3$, $O_8$, $^{210}$ Pb, $^{60}$ Co, $^{137}$ Cs, $^{90}$ Sr, $^{22}$ Na, $^{51}$ Cr, $^{54}$ Mn, $^{57}$ Co, $^{133}$ Ba, nuclides of uranium series, nuclides of thorium series, nuclides of actinium series, and naturally existing radioactive nuclides.

4. A random number generator (30) comprising a random pulse generator according to any preceding claim, output means for receiving the pulses from the random pulse generator, calculating the number of the random pulses by a predetermined time interval, and transmitting the number of the pulses as an output of random numbers.

5. A probability generator (40) comprising a random pulse generator according to any of claims 1 to 3, pulse counting means (41) for receiving the pulses from the random pulse generator, calculating the number of the random pulses by a predetermined time interval, and

signal output means for transmitting a predetermined signal ("hit" signal) when the number of the pulses calculated by the pulse counter means is coincident with the number of the pulses correspondent with a predetermined probability.

# FIG. 1

# FIG. 2

# FIG. 3

# FIG. 4

## FIG. 5

## FIG. 6

## FIG. 7

## FIG. 8

## FIG. 9

## FIG. 10

# FIG. 11

10(RS)

CPU

# FIG. 12

10(RS)

CPU

# FIG. 13

10

RS

10

**European Patent Office**

**EUROPEAN SEARCH REPORT**

Application Number

EP 00 30 8113

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | PATENT ABSTRACTS OF JAPAN vol. 1997, no. 06, 30 June 1997 (1997-06-30) -& JP 09 028899 A (TSUYUSAKI NORIHEI;TSUYUSAKI TOMOKO), 4 February 1997 (1997-02-04) * Figure 6 at page 15 * * abstract * | 1-5 | H03K3/84 G06F7/58 |
| Y | DE 197 39 732 A (MIROW GEORG DIETER DR) 25 March 1999 (1999-03-25) * column 1, line 13 - column 1, line 51 * | 1-5 | |
| Y | EP 0 828 349 A (AMERSHAM INT PLC) 11 March 1998 (1998-03-11) * column 4, line 53 - column 5, line 18 * | 1-5 | |
| A | DE 22 17 720 B (DIPL.-ING. W. SCHICKEDANZ) 12 July 1973 (1973-07-12) * column 4, line 16 - column 4, line 34 * | 1-5 | |
| A | PATENT ABSTRACTS OF JAPAN vol. 1995, no. 01, 28 February 1995 (1995-02-28) -& JP 06 291620 A (OKUMURA YUKI KK), 18 October 1994 (1994-10-18) * Figure 1 at page 9 * * abstract * | 1-5 | TECHNICAL FIELDS SEARCHED (Int.Cl.7) H03K G06F |
| A | PATENT ABSTRACTS OF JAPAN vol. 1995, no. 09, 31 October 1995 (1995-10-31) -& JP 07 162276 A (OKUMURA YUKI KK;OTHERS: 01), 23 June 1995 (1995-06-23) * Figure 6 at page 12 * * abstract * | 1-5 | |

The present search report has been drawn up for all claims

| Place of search | Date of completion of the search | Examiner |
|---|---|---|
| MUNICH | 28 February 2001 | Oloff, H |

EPO FORM 1503 03.82 (P04C01)

## ANNEX TO THE EUROPEAN SEARCH REPORT
## ON EUROPEAN PATENT APPLICATION NO.

EP 00 30 8113

This annex lists the patent family members relating to the patent documents cited in the above-mentioned European search report.
The members are as contained in the European Patent Office EDP file on
The European Patent Office is in no way liable for these particulars which are merely given for the purpose of information.

28-02-2001

| Patent document cited in search report | | Publication date | Patent family member(s) | | Publication date |
|---|---|---|---|---|---|
| JP 09028899 | A | 04-02-1997 | JP | 2926539 B | 28-07-1999 |
| DE 19739732 | A | 25-03-1999 | NONE | | |
| EP 0828349 | A | 11-03-1998 | AU | 3780697 A | 25-02-1998 |
| | | | CN | 1227679 A | 01-09-1999 |
| | | | EP | 0940011 A | 08-09-1999 |
| | | | WO | 9806175 A | 12-02-1998 |
| | | | JP | 2000515699 T | 21-11-2000 |
| DE 2217720 | B | 12-07-1973 | NONE | | |
| JP 06291620 | A | 18-10-1994 | JP | 2806736 B | 30-09-1998 |
| JP 07162276 | A | 23-06-1995 | NONE | | |

EPO FORM P0459

For more details about this annex : see Official Journal of the European Patent Office, No. 12/82